(19)

**Europäisches Patentamt**
**European Patent Office**
**Office européen des brevets**

(11) **EP 4 167 469 B1**

(12) **EUROPEAN PATENT SPECIFICATION**

(45) Date of publication and mention
of the grant of the patent:
**08.05.2024  Bulletin 2024/19**

(21) Application number: **21916642.8**

(22) Date of filing: **30.08.2021**

(51) International Patent Classification (IPC):
**H02P 23/14** *(2006.01)*      **G01R 31/34** *(2020.01)*

(52) Cooperative Patent Classification (CPC):
**H02P 23/14; G01R 31/343**

(86) International application number:
**PCT/CN2021/115460**

(87) International publication number:
**WO 2023/028783 (09.03.2023 Gazette 2023/10)**

(54) **METHOD AND APPARATUS FOR UPDATING CALIBRATION DATA OF MOTOR, ELECTRONIC DEVICE, AND STORAGE MEDIUM**

VERFAHREN UND VORRICHTUNG ZUR AKTUALISIERUNG VON KALIBRIERUNGSDATEN EINES MOTORS, ELEKTRONISCHE VORRICHTUNG UND SPEICHERMEDIUM

PROCÉDÉ ET APPAREIL DE MISE À JOUR DE DONNÉES D'ÉTALONNAGE DE MOTEUR, DISPOSITIF ÉLECTRONIQUE ET SUPPORT DE STOCKAGE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**19.04.2023  Bulletin 2023/16**

(73) Proprietor: **Contemporary Amperex Technology Co., Limited**
**Ningde City, Fujian 352100 (CN)**

(72) Inventors:
  • **ZHENG, Xiong**
    **Ningde City, Fujian 352100 (CN)**
  • **PAN, Xianxi**
    **Ningde City, Fujian 352100 (CN)**
  • **LUO, Yu**
    **Ningde City, Fujian 352100 (CN)**

• **DAN, Zhimin**
  **Ningde City, Fujian 352100 (CN)**

(74) Representative: **Frick, Robert**
  **Lorenz Seidler Gossel**
  **Rechtsanwälte Patentanwälte**
  **Partnerschaft mbB**
  **Widenmayerstraße 23**
  **80538 München (DE)**

(56) References cited:
  **EP-A1- 3 809 580        WO-A1-2020/038107**
  **CN-A- 109 391 206        CN-A- 113 127 489**
  **CN-A- 113 127 489        CN-A- 113 238 995**
  **CN-A- 113 238 995        CN-B- 109 391 206**
  **JP-A- 2016 018 230        JP-A- 2016 018 230**

## Description

### TECHNICAL FIELD

This application relates to the technical field of automobile control, and in particular, to a method and device for updating calibration data of electric machine, an electronic device, and a storage medium.

### BACKGROUND

In a new-energy vehicle control algorithm, a mainstream concept is to implement data calibration of a permanent-magnet synchronous machine, such as calibration of a maximum torque per ampere (MTPA) and flux weakening data, by using a lookup table matrix.

However, currently, perturbations usually occur in a process of calibrating lookup table data when the calibration is implemented by using the lookup table matrix, and affect an electric machine drastically especially in a case of a large torque. In addition, in the case of a large torque, a torque variation range is very wide. Such factors may cause lack of exact accuracy of the calibration data obtained by the calibration. Consequently, erroneous calibration data exists in the lookup table, and the formed lookup table data is inaccurate, thereby impairing safety of the electric machine in operation.

A method and a device for updating calibration data of an electric machine are disclosed in Shen Zhang et al., "Machine learning for the control and monitoring of electric machine drives: Advances and Trends", Arxiv.org, Cornell University Library, 201 OLIN Library Cornell University Ithaca, NY 14853, 18 February 2023.

### SUMMARY

An objective of embodiments of this application is to provide a method and device for updating calibration data of an electric machine, an electronic device, and a storage medium to solve the foregoing problems.

According to a first aspect, the present invention provides a method for updating calibration data of an electric machine. The method includes: obtaining an initial calibration datum of the electric machine, where the initial calibration datum is a status parameter of the electric machine running under a preset calibration parameter; determining whether a deviation between the initial calibration datum and a theoretical calculation datum exceeds a first threshold, where the theoretical calculation datum is a theoretical status parameter of the electric machine running under the preset calibration parameter, and the theoretical calculation datum is obtained by calculating based on the preset calibration parameter; re-calibrating the electric machine based on the preset calibration parameter when the deviation between the initial calibration datum and the theoretical calculation datum exceeds the first threshold, and obtaining an updated calibration datum; determining whether a deviation between the updated calibration datum and the initial calibration datum exceeds a second threshold; and updating the initial calibration datum based on the updated calibration datum when the deviation between the updated calibration datum and the initial calibration datum does not exceed the second threshold.

In the method for updating calibration data of an electric machine designed above, after the electric machine is calibrated to obtain the initial calibration data according to the technical solution of this application, it is first determined whether the deviation between the initial calibration datum and the theoretical calculation datum exceeds the first threshold. The electric machine is re-calibrated based on the preset calibration parameter when the deviation between the initial calibration datum and the theoretical calculation datum exceeds the first threshold, that is, is relatively large, so that the updated calibration datum is obtained. Then it is determined whether the deviation between the updated calibration datum and the initial calibration datum exceeds the second threshold. Further, the initial calibration datum is updated based on the updated calibration datum when the deviation between the updated calibration datum and the initial calibration datum does not exceed the second threshold. The method in this solution can identify and rectify erroneous calibration data that occur in a real-time calibration process of the electric machine, improve reliability of the data obtained in the calibration process of the electric machine, and improve accuracy of a lookup table formed by the calibration data, thereby improving safety of the electric machine in operation.

In an optional implementation of the first aspect, the method further includes: re-calibrating the electric machine based on the preset calibration parameter when the deviation between the updated calibration datum and the initial calibration datum exceeds the second threshold, and obtaining a second updated calibration datum; determining whether a deviation between the second updated calibration datum and the updated calibration datum exceeds the second threshold; and updating the initial calibration datum based on the second updated calibration datum when the deviation between the second updated calibration datum and the updated calibration datum does not exceed the second threshold.

In an optional implementation of the first aspect, the determining whether a deviation between the initial calibration datum and theoretical calculation datum exceeds a first threshold includes: determining whether a difference between the initial calibration datum and the theoretical calculation datum exceeds the first threshold; or, determining whether a ratio of the initial calibration datum to the theoretical calculation datum exceeds the first threshold.

In an optional implementation of the first aspect, the determining whether a deviation between the updated calibration datum and the initial calibration datum exceeds a second threshold includes: determining whether an absolute value of a difference between the updated calibration datum and the initial calibration datum exceeds the second threshold; or, determining whether an absolute value of a ratio of the updated calibration datum to the initial calibration datum exceeds the second threshold.

According to a second aspect, the present invention provides a device for updating calibration data of an electric machine. The device includes: a first obtaining module, configured to obtain an initial calibration datum of the electric machine, where the initial calibration datum is a status parameter of the electric machine running under a preset calibration parameter; a first determining module, configured to determine whether a deviation between the initial calibration datum and a theoretical calculation datum exceeds a first threshold, where the theoretical calculation datum is a theoretical status parameter of the electric machine running under the preset calibration parameter, and the theoretical calculation datum is obtained by calculating based on the preset calibration parameter; a first calibration module, configured to re-calibrate the electric machine based on the preset calibration parameter after the first determining module determines that the deviation between the initial calibration datum and the theoretical calculation datum exceeds the first threshold, and obtain an updated calibration datum, where the first determining module is further configured to determine whether a deviation between the updated calibration datum and the initial calibration datum exceeds a second threshold; and a first update module, configured to update the initial calibration datum based on the updated calibration datum after the first determining module determines that the deviation between the updated calibration datum and the initial calibration datum does not exceed the second threshold.

In the device for updating calibration data of an electric machine designed above, after the electric machine is calibrated to obtain the initial calibration data according to the technical solution of this application, it is first determined whether the deviation between the initial calibration datum and the theoretical calculation datum exceeds the first threshold. The electric machine is re-calibrated based on the preset calibration parameter when the deviation between the initial calibration datum and the theoretical calculation datum exceeds the first threshold, that is, is relatively large, so that the updated calibration datum is obtained. Then it is determined whether the deviation between the updated calibration datum and the initial calibration datum exceeds the second threshold. Further, the initial calibration datum is updated based on the updated calibration datum when the deviation between the updated calibration datum and the initial calibration datum does not exceed the second threshold. The method in this solution can identify and rectify erroneous calibration data that occur in a real-time calibration process of the electric machine, improve reliability of the data obtained in the calibration process of the electric machine, and improve accuracy of a lookup table formed by the calibration data, thereby improving safety of the electric machine in operation.

In an optional implementation of the second aspect, the first calibration module is further configured to re-calibrate the electric machine based on the preset calibration parameter when the first determining module determines that the deviation between the initial calibration datum and the theoretical calculation datum exceeds the second threshold, and obtain a second updated calibration datum. The first determining module is further configured to determine whether a deviation between the second updated calibration datum and the updated calibration datum exceeds the second threshold. The first update module is further configured to update the initial calibration datum based on the second updated calibration datum when the deviation between the second updated calibration datum and the updated calibration datum does not exceed the second threshold.

In an optional implementation of the second aspect, the first determining module is specifically configured to determine whether a difference between the initial calibration datum and the theoretical calculation datum exceeds the first threshold; or, determine whether a ratio of the initial calibration datum to the theoretical calculation datum exceeds the first threshold.

In an optional implementation of the second aspect, the first determining module is further specifically configured to determine whether an absolute value of a difference between the updated calibration datum and the initial calibration datum exceeds the second threshold; or, determine whether an absolute value of a ratio of the updated calibration datum to the initial calibration datum exceeds the second threshold.

According to another aspect, this application provides an electronic device, including a memory and a processor. The memory stores a computer program. When executing the computer program, the processor performs the method according to the first aspect, or any optional implementation of the first aspect.

According to another aspect, this application provides a storage medium on which a computer program is stored. When executed by a processor, the computer program performs the method according to the first aspect, or any optional implementation of the first aspect.

According to another aspect, this application provides a computer program product. When the computer program product is run on a computer, the computer is caused to perform the method according to the first aspect, or any optional implementation of the first aspect.

**BRIEF DESCRIPTION OF DRAWINGS**

To describe technical solutions in embodiments of this application more clearly, the following outlines the drawings to be used in the embodiments of this application.

FIG. 1 is a first flowchart of a method for updating calibration data of an electric machine according to an embodiment of this application;

FIG. 2 is a second flowchart of a method for updating calibration data of an electric machine according to an embodiment of this application;

FIG. 3 is a third flowchart of a method for updating calibration data of an electric machine according to an embodiment of this application;

FIG. 4 is a schematic structural diagram of a device for updating calibration data of an electric machine according to an embodiment of this application;

FIG. 5 is a first flowchart of another method for updating calibration data of an electric machine according to an embodiment of this application;

FIG. 6 is a second flowchart of another method for updating calibration data of an electric machine according to an embodiment of this application;

FIG. 7 is a third flowchart of another method for updating calibration data of an electric machine according to an embodiment of this application;

FIG. 8 is a structural diagram of another device for updating calibration data of an electric machine according to an embodiment of this application; and

FIG. 9 is a schematic structural diagram of an electronic device according to an embodiment of this application.

Reference numerals: 400-first obtaining module; 410-first determining module; 420-first calibration module; 430-first update module; 800-second obtaining module; 810-second determining module; 820-second calibration module; 830-second update module; 9-electronic device; 901-processor; 902-memory; and 90-communications bus.

**DETAILED DESCRIPTION OF EMBODIMENTS**

The following describes technical solutions in embodiments of this application with reference to the drawings in the embodiments of this application.

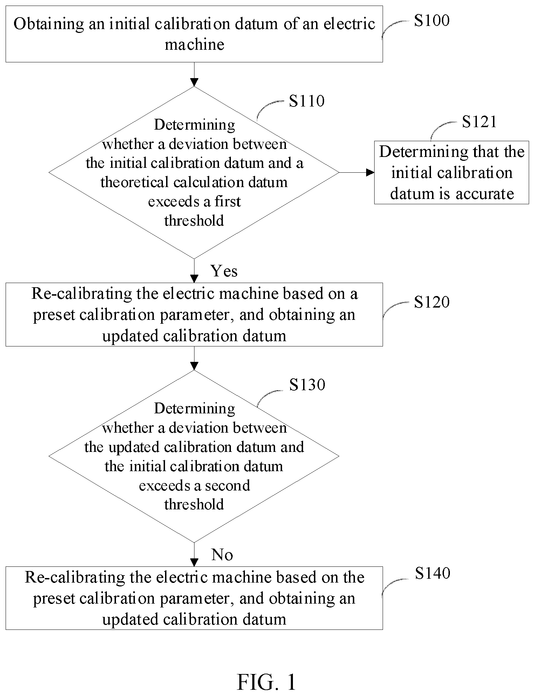

In a feasible implementation of this solution, an embodiment of this application provides a method for updating calibration data of an electric machine. The method is applicable to a control chip or computing device of the electric machine. The method can update and rectify real-time calibration data of the electric machine. As shown in FIG. 1, the method may include the following steps:

Step S100: Obtaining an initial calibration datum of an electric machine;

Step S110: Determining whether a deviation between the initial calibration datum and a theoretical calculation datum exceeds a first threshold; if the deviation exceeds the first threshold, going to step S 120 to step S 140; if the deviation does not exceed the first threshold, going to step S121;

Step S121: Determining that the initial calibration datum is accurate;

Step S 120: Re-calibrating the electric machine based on a preset calibration parameter, and obtaining an updated calibration datum;

Step S130: Determining whether a deviation between the updated calibration datum and the initial calibration datum exceeds a second threshold; if the deviation does not exceed the second threshold, going to step S140; and

Step S140: Updating the initial calibration datum based on the updated calibration datum.

In step S 100, the initial calibration datum of the electric machine represents a status parameter of the electric machine running under preset calibration parameter. The preset calibration parameters may be a preset no-load current calibration parameter, a preset flux weakening calibration parameter, or a preset maximum torque per ampere parameter, or the like. For example, if the preset calibration parameters are preset no-load current calibration parameters, the preset no-load current calibration parameters may be: an angle between a stator current of the electric machine and a d-axis is 180°, and a rotation speed of the electric machine is a rated rotation speed, a back electromotive force of the electric machine is equal to an operating current of the electric machine running at a preset voltage threshold. When the electric machine is run under the foregoing preset no-load current calibration parameters, the status parameters of the electric machine running under the preset no-load current calibration parameters can be obtained. The status parameters may include currents of a d-axis and q-axis of the stator of the electric machine, and a torque and a rotation speed of the electric machine. The status parameters are initial calibration data of the electric machine running under the preset no-load current calibration parameters.

It needs to be noted that a calibration process of the electric machine may be any existing calibration process, and does not fall within the protection scope of this application.

In step S100, in a possible implementation, the initial calibration datum of the electric machine may be obtained by collecting the status parameter of the electric machine in real time while controlling the electric machine to run under the preset calibration parameter. In another possible implementation, the initial calibration datum of the electric machine may be obtained by receiving, from an external device, the status parameter of the electric machine running under the preset calibration parameter.

In step S110, the theoretical calculation datum is a theoretical status parameter of the electric machine running under the preset calibration parameter. The theoretical calculation datum may be obtained by calculating in real time based on the preset calibration parameter and a theoretical calculation formula, or may be calculated in advance based on the preset calibration parameter and the theoretical calculation formula and then stored in a computing device. The theoretical calculation formula may be deduced by a Lagrangian multiplier method. Specifically, in a case of the maximum torque per ampere, the theoretical formulas for calculating the d-axis and q-axis currents may be:

$$i_q = \frac{\left(\frac{8T_e\varphi_f}{3Pn}\right) + \sqrt{\left(\frac{8T_e\varphi_f}{3Pn}\right)^2 - 4\left[\varphi_f^2 - 4(L_d - L_q)^2\right] \cdot \left[\left(\frac{4T_e}{3Pn}\right)^2 - \varphi_f^2\right]}}{2\left[\varphi_f^2 - 4(L_d - L_q)^2\right]};$$

and

$$i_d = -\left[\frac{\varphi_f}{2} \times (L_d - L_q)\right] + \sqrt{\frac{\varphi_f^2}{4(L_d - L_q)^2} + i_q^2},$$

respectively.

When the electric machine reaches a critical rotation speed through the maximum torque per ampere, the electric machine enters a flux weakening calibration mode. In the flux weakening calibration mode, the theoretical formulas for calculating the d-axis and q-axis currents may be:

$$i_q^2 + i_d^2 = i_{max}^2;$$

and

$$i_d = \frac{-2L_d\varphi_f + \sqrt{(2L_d\varphi_f)^2 - 4(L_d^2 - L_q^2)(\varphi_f^2 + L_q^2 i_{max}^2 - (u_{lim}/\omega_e)^2)}}{2(L_d^2 - L_q^2)},$$

respectively.

When the electric machine enters a deep flux weakening mode, the theoretical formulas for calculating the d-axis and q-axis currents may be:

$$\left(L_d i_q\right)^2 + \left(L_d i_d + \varphi_f\right)^2 = (u_{lim}/\omega_e)^2;$$

and

$$i_d = -\frac{\varphi_f}{2L_d} + \frac{-L_d\varphi_f + \sqrt{L_d^2\varphi_f^2 + 4L_q^2(L_d - L_q)^2 i_q^2}}{2L_d(L_d - L_q)},$$

respectively.

In the formula above, $i_q$ represents the q-axis current of the stator of the electric machine; $T_e$ represents a torque; $P_n$ represents the number of pole pairs; $L_d$ represents a d-axis inductance of the stator; $L_q$ represents a q-axis inductance of the stator; $\varphi_f$ represents a flux linkage; $u_{lim}$ is a preset upper-limit voltage; and $\omega_e$ represents an electrical

angular velocity.

In step S110, in a possible implementation, the determining whether a deviation between the initial calibration datum and the theoretical calculation datum exceeds the first threshold may be: determining whether a difference between the initial calibration datum and the theoretical calculation datum exceeds the first threshold.

In another possible implementation, the determining whether a deviation between the initial calibration datum and the theoretical calculation datum exceeds the first threshold may be: determining whether a ratio of the initial calibration datum to the theoretical calculation datum exceeds the first threshold. The deviation may be determined by other means different from the foregoing difference means and ratio means. For example, the deviation may be determined based on a weighted average value, or the like. The value of the first threshold may be set empirically.

On the above basis, if it is determined, in step S110, that the deviation between the initial calibration datum and the theoretical calculation datum does not exceed the first threshold, it indicates that the deviation between the initial calibration datum and the theoretical calculation datum is within a reasonable range. Therefore, step S121 is performed to determine that the initial calibration datum is accurate, and the initial calibration datum is left to remain unchanged.

If it is determined, in step S110, that the deviation between the initial calibration datum and the theoretical calculation datum exceeds the first threshold, it indicates that the deviation between the initial calibration datum and the theoretical calculation datum is relatively large. Therefore, step S120 is performed to re-calibrate the electric machine based on the preset calibration parameter, and an updated calibration datum is obtained. The re-calibration means that the electric machine is run under the preset calibration parameter again, and then the status parameter of the electric machine is obtained, the re-calibrated datum is obtained, and the updated calibration datum is obtained.

After the updated calibration datum is obtained, step S 130 may be performed to determine whether a deviation between the updated calibration datum and the initial calibration datum exceeds a second threshold. In a possible implementation, the determining whether a deviation between the updated calibration datum and the initial calibration datum exceeds the second threshold may be: determining whether a difference between the updated calibration datum and the initial calibration datum exceeds the second threshold.

In another possible implementation, the determining whether a deviation between the updated calibration datum and the initial calibration datum exceeds the second threshold may be: determining whether a ratio of the updated calibration datum to the initial calibration datum exceeds the second threshold, where the value of the second threshold may be set empirically, and the first threshold and the second threshold may be equal or unequal.

On the basis of the above, if the deviation between the updated calibration datum and the initial calibration datum does not exceed the second threshold, it indicates that the updated calibration datum obtained after the second calibration does not deviate much from the initial calibration datum obtained after the initial calibration. Therefore, in this solution, it is determined that the updated calibration datum is accurate, and then step S 140 is performed to update the initial calibration datum based on the updated calibration datum. In a possible implementation, if the initial calibration datum has been stored, the original initial calibration datum is replaced with the updated calibration datum. In another possible implementation, if the initial calibration datum has not been stored, the updated calibration datum and the corresponding preset calibration parameter are stored correspondingly.

In the method for updating calibration data of an electric machine designed above, after the electric machine is calibrated to obtain the initial calibration data according to the technical solution of this application, it is first determined whether the deviation between the initial calibration datum and the theoretical calculation datum exceeds the first threshold. The electric machine is re-calibrated based on the preset calibration parameter when the deviation between the initial calibration datum and the theoretical calculation datum exceeds the first threshold, that is, is relatively large, so that the updated calibration datum is obtained. Then it is determined whether the deviation between the updated calibration datum and the initial calibration datum exceeds the second threshold. Further, the initial calibration datum is updated based on the updated calibration datum when the deviation between the updated calibration datum and the initial calibration datum does not exceed the second threshold. The method in this solution can identify and rectify erroneous calibration data that occur in a real-time calibration process of the electric machine, improve reliability of the data obtained in the calibration process of the electric machine, and improve accuracy of a lookup table formed by the calibration data, thereby improving safety of the electric machine in operation.

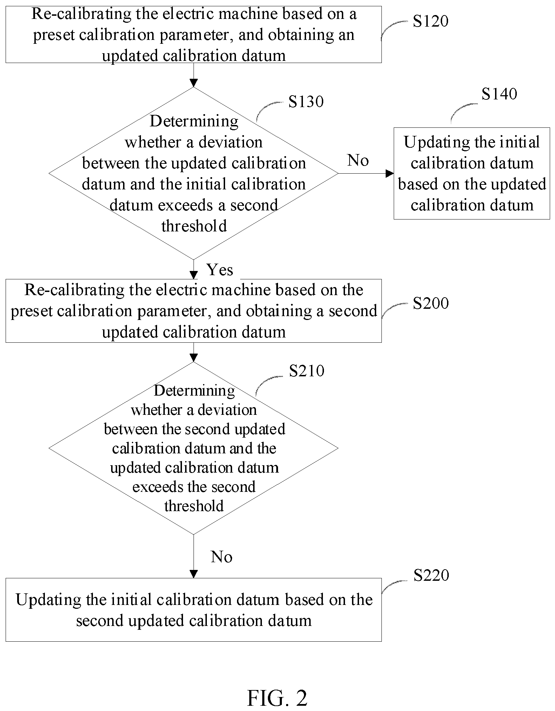

In an optional implementation of this embodiment, as a possible implementation, if it is determined, in step S130, that the deviation between the updated calibration datum and the initial calibration datum exceeds the second threshold, the solution in this application can further ensure the accuracy of the calibration datum through the following steps. As shown in FIG. 2, the steps include:

Step S200: Re-calibrating the electric machine based on the preset calibration parameter, and obtaining a second updated calibration datum;
Step S210: Determining whether a deviation between the second updated calibration datum and the updated calibration datum exceeds a second threshold; if the deviation does not exceed the second threshold, going to step S220; and

Step S220: Updating the initial calibration datum based on the second updated calibration datum.

If the deviation between the updated calibration datum and the initial calibration datum exceeds the second threshold, it indicates that the deviation between the updated calibration datum and the initial calibration datum is relatively large. In this case, step S200 is performed to re-calibrate the electric machine based on the preset calibration parameter, and then a second updated calibration datum is obtained.

On the basis of obtaining the second updated calibration datum, step S210 is performed to determine whether the deviation between the second updated calibration datum and the updated calibration datum exceeds the second threshold. If the deviation between the second updated calibration datum and the updated calibration datum does not exceed the second threshold, it is determined that the second updated calibration datum is accurate, and then the initial calibration datum is updated based on the second updated calibration datum.

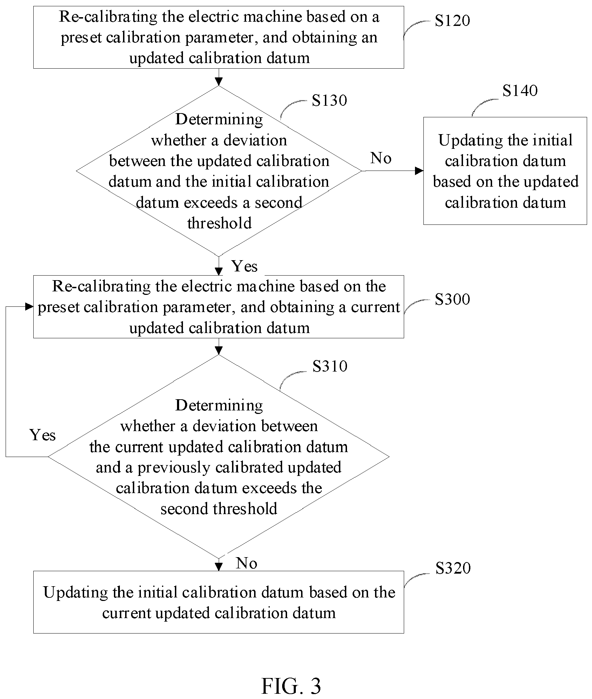

In another possible implementation, if it is determined, in step S130, that the deviation between the updated calibration datum and the initial calibration datum exceeds the second threshold, the solution in this application can further ensure the accuracy of the calibration datum through the following steps. As shown in FIG. 3, the steps include:

Step S300: Re-calibrating the electric machine based on the preset calibration parameter, and obtaining a current updated calibration datum;
Step S310: Determining whether a deviation between the current updated calibration datum and the previously calibrated updated calibration datum exceeds the second threshold; if the deviation exceeds the second threshold, going to step S300; if the deviation does not exceed the second threshold, going to step S320; and
Step S320: Updating the initial calibration datum based on the current updated calibration datum.

In the foregoing steps, this solution not only re-calibrates the electric machine, but also performs re-calibration whenever the deviation between the current updated calibration datum and the previously calibrated updated calibration datum exceeds the second threshold. To be specific, if the deviation between the current updated calibration datum and the previously calibrated updated calibration datum repeatedly exceeds the second threshold, the determining about the calibration is performed cyclically, without being limited to the solution in the preceding implementation in which the re-calibration is performed once again.

In the method designed above, this solution first determines whether the deviation between the initial calibration datum and the theoretical calculation datum exceeds the first threshold. When the deviation exceeds the first threshold, the electric machine is re-calibrated by using the preset calibration parameter, and the deviation between the calibration datum obtained through the re-calibration and the calibration datum obtained in the previous calibration is calculated. If the deviation does not exceed the second threshold, the initial calibration datum is updated by using the calibration datum obtained through the re-calibration. The method in this solution can identify and rectify erroneous calibration data that occur in a calibration process of the electric machine, improve reliability of the calibration data of the electric machine, and ensure accuracy of the data in the lookup table formed by the calibration data, thereby improving safety of the electric machine in operation.

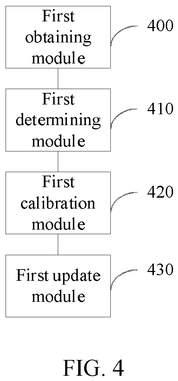

FIG. 4 is a schematic structural block diagram of a device for updating calibration data of an electric machine according to this application. Understandably, the device corresponds to the method embodiment shown in FIG. 1 to FIG. 3, and can implement the steps in the foregoing method. Specific functions of the device may be learned by referring to the foregoing description, and the detailed description is duly omitted here to avoid repetition. The device includes at least one software function module that can be stored in a memory or built in an operating system (OS) of the device in the form of software or firmware (firmware). Specifically, the device includes: a first obtaining module 400, configured to obtain an initial calibration datum of the electric machine, where the initial calibration datum is a status parameter of the electric machine running under a preset calibration parameter; a first determining module 410, configured to determine whether a deviation between the initial calibration datum and a theoretical calculation datum exceeds a first threshold, where the theoretical calculation datum is a theoretical status parameter of the electric machine running under the preset calibration parameter, and the theoretical calculation datum is obtained by calculating based on the preset calibration parameter; a first calibration module 420, configured to re-calibrate the electric machine based on the preset calibration parameter after the first determining module 410 determines that the deviation between the initial calibration datum and the theoretical calculation datum exceeds the first threshold, and obtain an updated calibration datum, where the first determining module 410 is further configured to determine whether a deviation between the updated calibration datum and the initial calibration datum exceeds a second threshold; and a first update module 430, configured to update the initial calibration datum based on the updated calibration datum after the first determining module 410 determines that the deviation between the updated calibration datum and the initial calibration datum does not exceed the second threshold.

In the device for updating calibration data of an electric machine designed above, after the electric machine is calibrated to obtain the initial calibration data according to the technical solution of this application, it is first determined whether the deviation between the initial calibration datum and the theoretical calculation datum exceeds the first threshold. The electric machine is re-calibrated based on the preset calibration datum when the deviation between the initial calibration parameter and the theoretical calculation datum exceeds the first threshold, that is, is relatively large, so that the updated calibration datum is obtained. Then it is determined whether the deviation between the updated calibration datum and the initial calibration datum exceeds the second threshold. Further, the initial calibration datum is updated based on the updated calibration datum when the deviation between the updated calibration datum and the initial calibration datum does not exceed the second threshold. The method in this solution can identify and rectify erroneous calibration data that occur in a calibration process of the electric machine, improve reliability of the calibration data of the electric machine, and ensure accuracy of the data in the lookup table formed by the calibration data, thereby improving safety of the electric machine in operation.

In an optional implementation of this embodiment, the first calibration module 420 is further configured to re-calibrate the electric machine based on the preset calibration parameter when the first determining module 410 determines that the deviation between the initial calibration datum and the theoretical calculation datum exceeds the second threshold, and obtain a second updated calibration datum. The first determining module 410 is further configured to determine whether a deviation between the second updated calibration datum and the updated calibration datum exceeds the second threshold. The first update module 430 is further configured to update the initial calibration datum based on the second updated calibration datum when the deviation between the second updated calibration datum and the updated calibration datum does not exceed the second threshold.

In an optional implementation of this embodiment, the first determining module 410 is specifically configured to determine whether a difference between the initial calibration datum and the theoretical calculation datum exceeds the first threshold; or, determine whether a ratio of the initial calibration datum to the theoretical calculation datum exceeds the first threshold.

In an optional implementation of this embodiment, the first determining module 410 is further specifically configured to determine whether an absolute value of a difference between the updated calibration datum and the initial calibration datum exceeds the second threshold; or, determine whether an absolute value of a ratio of the updated calibration datum to the initial calibration datum exceeds the second threshold.

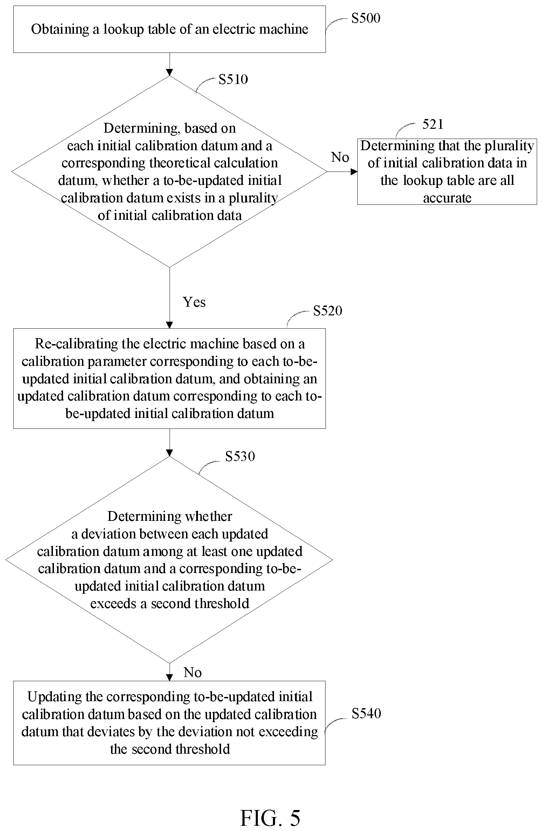

In another feasible implementation of this solution, this application provides another method for updating calibration data of an electric machine. The method is applicable to a control chip or computing device of the electric machine. The method can update and rectify calibration data in a lookup table of the electric machine. As shown in FIG. 5, the method may include the following steps:

> Step S500: Obtaining a lookup table of an electric machine;
> Step S510: Determining, based on each initial calibration datum and a corresponding theoretical calculation datum, whether a to-be-updated initial calibration datum exists in a plurality of initial calibration data; if the to-be-updated initial calibration datum exists, going to step S520; if the to-be-updated initial calibration datum does not exist, going to step S521;
> Step S520: Re-calibrating the electric machine based on a calibration parameter corresponding to each to-be-updated initial calibration datum, and obtaining an updated calibration datum corresponding to each to-be-updated initial calibration datum;
> Step S530: Determining whether a deviation between each updated calibration datum among at least one updated calibration datum and a corresponding to-be-updated initial calibration datum exceeds a second threshold; if the deviation does not exceed the second threshold, going to step S540; if the deviation exceeds the second threshold, going to step S600;
> Step S540: Updating the corresponding to-be-updated initial calibration datum based on the updated calibration datum that deviates by the deviation not exceeding the second threshold; and
> Step S521: Determining that the plurality of initial calibration data in the lookup table are all accurate.

In step S500, the lookup table of the electric machine includes a plurality of initial calibration data. Each initial calibration datum is a status parameter of the electric machine running under a corresponding calibration parameter, and different calibration data correspond to different calibration parameters. The lookup table may include an initial calibration datum of a no-load current, an initial calibration datum of a maximum torque per ampere, an initial calibration datum of a flux weakening stage, and a calibration parameter mapped to each calibration datum, and the like. In addition, the lookup table of the electric machine may be obtained by accessing a stored lookup table.

In step S510, each initial calibration datum corresponds to a theoretical calculation datum. The theoretical calculation datum corresponding to each initial calibration datum can be obtained by calculating based on the calibration parameter corresponding to the initial calibration datum by using the theoretical calculation formula mentioned in the first embodiment.

In step S510, this solution can calculate the deviation between each initial calibration datum and a corresponding theoretical calculation datum, and then determine whether the deviation between each initial calibration datum and the corresponding theoretical calculation datum exceeds the first threshold. In this way, it is determined whether a to-be-updated initial calibration datum exists in the plurality of initial calibration data, thereby sifting the to-be-updated initial calibration data.

If the deviation between the initial calibration datum and the corresponding theoretical calculation datum exceeds the first threshold, it indicates that the initial calibration datum is a to-be-updated initial calibration datum. If the deviation between the initial calibration datum and the corresponding theoretical calculation datum does not exceed the first threshold, it indicates that the initial calibration datum is not a to-be-updated initial calibration datum. The deviation between the initial calibration datum and the corresponding theoretical calculation datum may be a difference between the initial calibration datum and the corresponding theoretical calculation datum; or may be a ratio of the initial calibration datum to the corresponding theoretical calculation datum.

If it is determined, in the way above, that no to-be-updated initial calibration datum exists in the plurality of initial calibration data, it indicates that the plurality of initial calibration data in the lookup table are all accurate, and step S521 is performed, without a need to update the initial calibration datum.

If it is determined, in the way above, that a to-be-updated initial calibration datum exists in the plurality of initial calibration data, the to-be-updated initial calibration datum needs to be processed, and step S520 is performed to re-calibrate the electric machine based on the calibration parameter corresponding to each to-be-updated initial calibration datum, thereby obtaining an updated calibration datum corresponding to each to-be-updated initial calibration datum.

After the updated calibration datum corresponding to each to-be-updated initial calibration datum is obtained, it is determined whether a deviation between each updated calibration datum among the at least one updated calibration datum and the corresponding to-be-updated initial calibration datum exceeds the second threshold. To be specific, the deviation between each updated calibration datum and the corresponding to-be-updated initial calibration datum is calculated, and then it is determined whether each deviation exceeds the second threshold.

If the deviation by which the to-be-updated initial calibration datum deviates does not exceed the second threshold, it indicates that the updated calibration datum corresponding to the to-be-updated initial calibration datum is accurate. Therefore, the corresponding to-be-updated initial calibration datum is updated based on the updated calibration datum that deviates by the deviation not exceeding the second threshold.

In the method for updating calibration data of an electric machine designed above, in the solution of this application, a lookup table containing a plurality of initial calibration data is obtained first. Then it is determined whether a to-be-updated initial calibration datum exists in the plurality of initial calibration data with respect to each initial calibration datum in the lookup table and the corresponding theoretical calculation datum. Then the electric machine is re-calibrated based on the calibration parameter corresponding to each to-be-updated initial calibration datum, and the updated calibration datum corresponding to each to-be-updated initial calibration datum is obtained. Further, it is determined whether the deviation between each updated calibration datum among at least one updated calibration datum and the corresponding to-be-updated initial calibration datum exceeds the second threshold. Finally, the corresponding to-be-updated initial calibration datum is updated based on the updated calibration datum that deviates by the deviation not exceeding the second threshold. As can be seen, the method in this solution can identify erroneous initial calibration data in the lookup table, and the erroneous initial calibration data in the lookup table can be updated, thereby improving reliability of the calibration data in the lookup table, improving accuracy of the lookup table formed by the calibration data, and improving safety of the electric machine in operation.

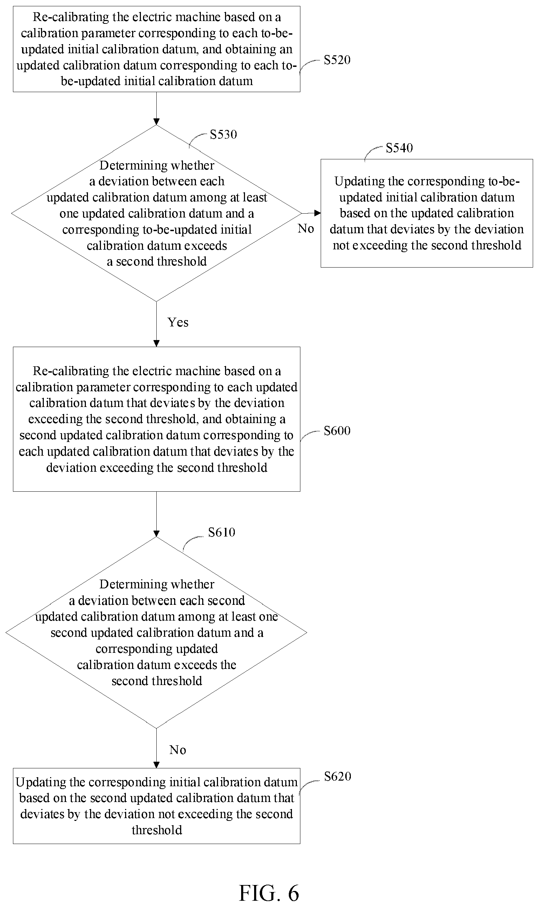

In an optional implementation of this embodiment, as a possible implementation, if it is determined, in step S530, that the deviation between the updated calibration datum and the corresponding to-be-updated initial calibration datum exceeds the second threshold, the accuracy of the calibration datum can be further ensured through the following steps. As shown in FIG. 6, the steps include:

Step S600: Re-calibrating the electric machine based on a calibration parameter corresponding to each updated calibration datum that deviates by the deviation exceeding the second threshold, and obtaining a second updated calibration datum corresponding to each updated calibration datum that deviates by the deviation exceeding the second threshold;

Step S610: Determining whether a deviation between each second updated calibration datum among at least one second updated calibration datum and a corresponding updated calibration datum exceeds a second threshold; if the deviation does not exceed the second threshold, going to step 5620; and

Step S620: Updating the corresponding initial calibration datum based on the second updated calibration datum that deviates by the deviation not exceeding the second threshold.

In the foregoing steps, the electric machine is re-calibrated based on the calibration parameter corresponding to the updated calibration datum that deviates by the deviation exceeding the second threshold, so as to obtain a second updated calibration datum corresponding to each updated calibration datum that deviates by the deviation exceeding the second threshold. Then it is determined whether the deviation between each second updated calibration datum and the corresponding updated calibration datum exceeds the second threshold. If the deviation does not exceed the second threshold, it indicates that the second updated calibration datum is accurate, and therefore, the corresponding initial calibration datum is updated based on the second updated calibration datum that deviates by the deviation not exceeding the second threshold.

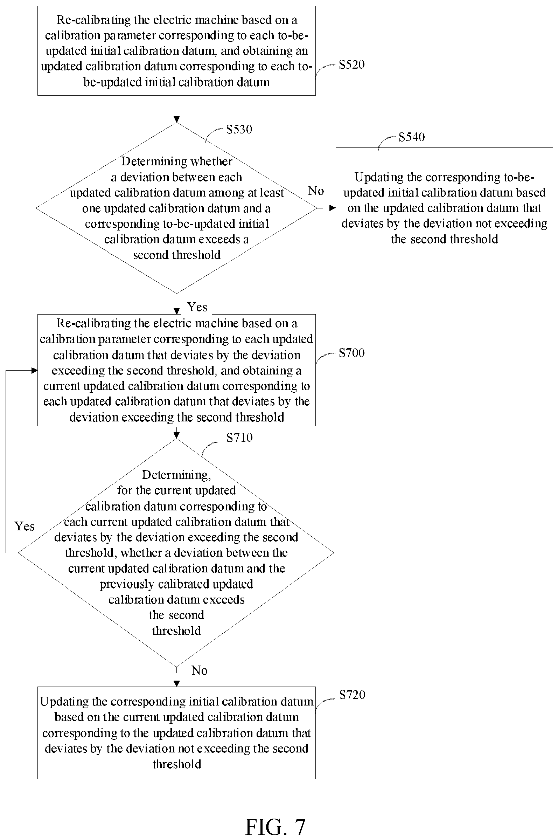

In another possible implementation, if it is determined, in step S530, that the deviation between the updated calibration datum and the corresponding to-be-updated initial calibration datum exceeds the second threshold, this solution can further ensure the accuracy of the calibration datum through the following steps. As shown in FIG. 7, the steps include:

Step S700: Re-calibrating the electric machine based on a calibration parameter corresponding to each updated calibration datum that deviates by the deviation exceeding the second threshold, and obtaining a current updated calibration datum corresponding to each updated calibration datum that deviates by the deviation exceeding the second threshold;

Step S710: Determining, for the current updated calibration datum corresponding to each current updated calibration datum that deviates by the deviation exceeding the second threshold, whether a deviation between the current updated calibration datum and the previously calibrated updated calibration datum exceeds the second threshold; if the deviation does not exceed the second threshold, going to step S720; if the deviation exceeds the second threshold, going to step S700;

Step S720: Updating the corresponding initial calibration datum based on the current updated calibration datum corresponding to the updated calibration datum that deviates by the deviation not exceeding the second threshold.

This solution not only re-calibrates the electric machine, but also performs re-calibration whenever the deviation between the current updated calibration datum and the previously calibrated updated calibration datum exceeds the second threshold. To be specific, if the deviation between the current updated calibration datum and the previously calibrated updated calibration datum repeatedly exceeds the second threshold, the determining about the calibration is performed cyclically, without being limited to the solution in the preceding implementation in which the re-calibration is performed once again to obtain the second updated calibration datum.

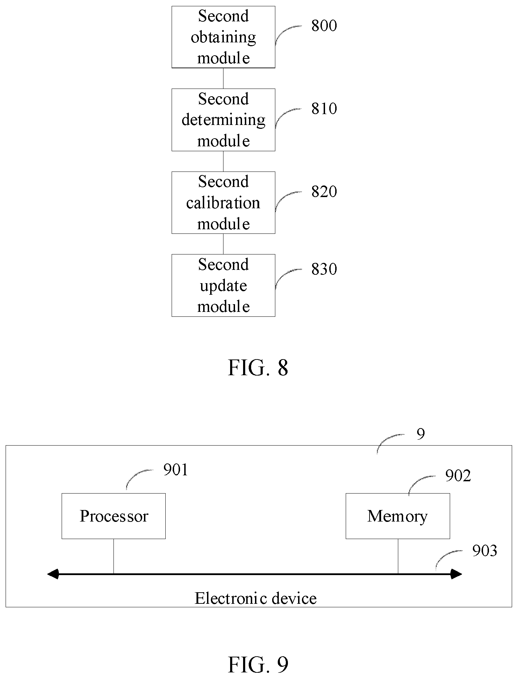

FIG. 8 is a schematic structural block diagram of another device for updating calibration data of an electric machine according to this application. Understandably, the device corresponds to the method embodiment shown in FIG. 5 to FIG. 7, and can implement the steps in the foregoing method. Specific functions of the device may be learned by referring to the foregoing description, and the detailed description is duly omitted here to avoid repetition. The device includes at least one software function module that can be stored in a memory or built in an operating system (OS) of the device in the form of software or firmware (firmware). Specifically, the device includes: a second obtaining module 800, configured to obtain a lookup table of the electric machine, where the lookup table includes a plurality of initial calibration data, each initial calibration datum is a status parameter of the electric machine running under a corresponding calibration parameter, and different initial calibration data correspond to different calibration parameters; a second determining module 810, configured to determine, based on each initial calibration datum and a corresponding theoretical calculation datum, whether a to-be-updated initial calibration datum exists in the plurality of initial calibration data, where the theoretical calculation datum is a theoretical status parameter of the electrical machine running under the corresponding calibration parameter, and the theoretical calculation datum is obtained by calculating based on the corresponding calibration parameter; a second calibration module 820, configured to re-calibrate, after the second determining module 810 determines that a to-be-rectified initial calibration datum exists among the plurality of initial calibration data, the electric machine based on a calibration parameter corresponding to each to-be-updated initial calibration datum, and obtain an updated calibration datum corresponding to each to-be-updated initial calibration datum, where the second determining module 810 is further configured to determine whether a deviation between each updated calibration datum among at least one updated calibration datum and a corresponding to-be-updated initial calibration datum exceeds a second threshold; and a second update module 830, configured to update, after the second determining module 810 determines that the deviation does not exceed the second threshold, the corresponding to-be-updated initial calibration datum based on the updated calibration datum that deviates by the deviation not exceeding the second threshold.

In the device for updating calibration data of an electric machine designed above, in the solution of this application, a lookup table containing a plurality of initial calibration data is obtained first. Then it is determined whether a to-be-updated initial calibration datum exists in the plurality of initial calibration data with respect to each initial calibration datum in the lookup table and the corresponding theoretical calculation datum. Then the electric machine is re-calibrated based on the calibration parameter corresponding to each to-be-updated initial calibration datum, and the updated calibration datum corresponding to each to-be-updated initial calibration datum is obtained. Further, it is determined whether the deviation between each updated calibration datum among at least one updated calibration datum and the corresponding to-be-updated initial calibration datum exceeds the second threshold. Finally, the corresponding to-be-updated initial calibration datum is updated based on the updated calibration datum that deviates by the deviation not exceeding the second threshold. As can be seen, the method in this solution can identify erroneous initial calibration data in the lookup table, and the erroneous initial calibration data in the lookup table can be updated, thereby improving reliability of the calibration data in the lookup table, improving accuracy of the lookup table formed by the calibration data, and improving safety of the electric machine in operation.

In an optional implementation of this embodiment, the second calibration module 820 is further configured to re-calibrate, when the second determining module 810 determines that the deviation exceeds the second threshold, the electric machine based on a calibration parameter corresponding to each updated calibration datum that deviates by the deviation exceeding the second threshold, and obtaining a second updated calibration datum corresponding to each updated calibration datum that deviates by the deviation exceeding the second threshold. The second determining module 810 is further configured to determine whether a deviation between each second updated calibration datum among at least one second updated calibration datum and a corresponding updated calibration datum exceeds the second threshold. The second update module 830 is further configured to update, when the second determining module 810 determines that the deviation between the second updated calibration datum and the corresponding updated calibration datum does not exceed the second threshold, the corresponding initial calibration datum based on the second updated calibration datum that deviates by the deviation not exceeding the second threshold.

In an optional implementation of this embodiment, the second determining module 810 is specifically configured to calculate a deviation between each initial calibration datum and a corresponding theoretical calculation datum; and determine, based on the deviation between each initial calibration datum and the corresponding theoretical calculation datum, whether a to-be-updated initial calibration datum exists in the plurality of initial calibration data.

In an optional implementation of this embodiment, the second determining module 810 is further specifically configured to determine whether an absolute value of a difference between each updated calibration datum among the at least one updated calibration datum and the corresponding to-be-updated initial calibration datum exceeds the second threshold; or, determine whether an absolute value of a ratio of each updated calibration datum among at least one updated calibration datum to a corresponding to-be-updated initial calibration datum exceeds the second threshold.

As shown in FIG. 9, this application provides an electronic device 9, including a processor 901 and a memory 902. The processor 901 is connected to and communicates with the memory 902 through a communications bus 903 and/or another form of connection mechanism (not shown). The memory 902 stores a computer program executable by the processor 901. When a computing device runs, the processor 901 executes the computer program to perform the method in any optional implementation described above, for example, to perform steps S100 to S130: obtaining an initial calibration datum of an electric machine; determining whether a deviation between the initial calibration datum and a theoretical calculation datum exceeds a first threshold; if the deviation exceeds the first threshold, re-calibrating the electric machine based on a preset calibration parameter, and obtaining an updated calibration datum; determining whether a deviation between the updated calibration datum and the initial calibration datum exceeds a second threshold; if the deviation does not exceed the second threshold, updating the initial calibration datum based on the updated calibration datum.

As another example, the computer program is executed to perform steps S500 to S540: obtaining a lookup table of an electric machine; determining, based on each initial calibration datum and a corresponding theoretical calculation datum, whether a to-be-updated initial calibration datum exists in a plurality of initial calibration data; if the to-be-updated initial calibration datum exists, re-calibrating the electric machine based on a calibration parameter corresponding to each to-be-updated initial calibration datum, and obtaining an updated calibration datum corresponding to each to-be-updated initial calibration datum; determining whether a deviation between each updated calibration datum among at least one updated calibration datum and a corresponding to-be-updated initial calibration datum exceeds a second threshold; if the deviation does not exceed the second threshold, updating the corresponding to-be-updated initial calibration datum based on the updated calibration datum that deviates by the deviation not exceeding the second threshold.

This application provides a storage medium. A computer program is stored in the storage medium. When executed by a processor, the computer program performs the method in any optional implementation described above.

The storage medium may be implemented by any type of volatile or non-volatile storage device or a combination thereof, for example, a static random access memory (SRAM), an electrically erasable programmable read-only memory (EEPROM for short), an erasable programmable read-only memory (EPROM for short), a programmable read-only memory (PROM for short), a read-only memory (ROM for short), a magnetic storage, a flash memory, a magnetic disk, or an optical disk.

This application provides a computer program product. When the computer program product is run on a computer, the computer is caused to perform the method in any optional implementation described above.

In the embodiments provided in this application, it is understandable that the disclosed device and method may be implemented by other means. The device embodiment described above is merely exemplary. For example, the unit division is merely division with respect to logical functions, and in actual implementations, the units may be divided in other manners. For another example, a plurality of units or components may be combined or integrated into another system, or some features may be ignored or not implemented. In addition, the displayed or discussed mutual couplings or direct couplings or communications connections may be implemented through some communications interfaces. The indirect couplings or communications connections between the devices or units may be implemented in electronic, mechanical or other forms.

In addition, the units described as discrete components above may be separated physically or not; and the components illustrated as units may be physical units or not, that is, they may be located in one place or distributed on a plurality of network elements. Some or all of the units may be selected according to actual needs to achieve the objectives of the solutions of the embodiments.

In addition, function modules in each embodiment of this application may be integrated together to form a stand-alone part, or each module may exist alone, or two or more modules may be integrated into a stand-alone part.

It needs to be noted that, when the functions are implemented in the form of a software functional module and sold or used as an independent product, the functions may be stored in a computer-readable storage medium. Based on such an understanding, the essence of the technical solution of this application, or the part making contributions to the prior art, or a part of the technical solution may be embodied in the form of a software product. The computer software product is stored in a storage medium, and includes several instructions for instructing a computer device (such as a personal computer, a server, a network device) to perform all or part of the steps of the method described in each embodiment of this application. The storage medium includes any medium that can store program code, for example, a USB flash disk, a removable hard disk, a read-only memory (ROM), a random access memory (RAM), a magnetic disk, or an optical disk.

The relational terms herein such as first and second are used merely to differentiate one entity or operation from another, and do not necessarily require or imply any actual relationship or sequence between the entities or operations.

**Claims**

1. A method for updating calibration data of an electric machine, wherein the method comprises:

   (S 100) obtaining an initial calibration datum of the electric machine, wherein the initial calibration datum is a status parameter of the electric machine running under a preset calibration parameter;
   (S110) determining whether a deviation between the initial calibration datum and a theoretical calculation datum exceeds a first threshold, wherein the theoretical calculation datum is a theoretical status parameter of the electric machine running under the preset calibration parameter, and the theoretical calculation datum is obtained by calculating based on the preset calibration parameter; and
   (S120) re-calibrating the electric machine based on the preset calibration parameter when the deviation between the initial calibration datum and the theoretical calculation datum exceeds the first threshold, and obtaining an updated calibration datum;
   **characterized in that**
   the method further comprises:

   (S130) determining whether a deviation between the updated calibration datum and the initial calibration datum exceeds a second threshold; and
   (S140) updating the initial calibration datum based on the updated calibration datum when the deviation between the updated calibration datum and the initial calibration datum does not exceed the second threshold.

2. The method according to claim 1, **characterized in that** the method further comprises:

   (S200) re-calibrating the electric machine based on the preset calibration parameter when the deviation between the updated calibration datum and the initial calibration datum exceeds the second threshold, and obtaining a second updated calibration datum;
   (S210) determining whether a deviation between the second updated calibration datum and the updated calibration datum exceeds the second threshold; and
   (S220) updating the initial calibration datum based on the second updated calibration datum when the deviation between the second updated calibration datum and the updated calibration datum does not exceed the second threshold.

3. The method according to claim 1, **characterized in that** the (S 110) determining whether a deviation between the initial calibration datum and theoretical calculation datum exceeds a first threshold comprises:
determining whether a difference between the initial calibration datum and the theoretical calculation datum exceeds the first threshold; or, determining whether a ratio of the initial calibration datum to the theoretical calculation datum exceeds the first threshold.

4. The method according to claim 1, **characterized in that** the (S130) determining whether a deviation between the updated calibration datum and the initial calibration datum exceeds a second threshold comprises:
determining whether an absolute value of a difference between the updated calibration datum and the initial calibration datum exceeds the second threshold; or, determining whether an absolute value of a ratio of the updated calibration datum to the initial calibration datum exceeds the second threshold.

5. A device for updating calibration data of an electric machine, wherein the device comprises:

   a first obtaining module (400), configured to obtain an initial calibration datum of the electric machine, wherein the initial calibration datum is a status parameter of the electric machine running under a preset calibration parameter;
   a first determining module (410), configured to determine whether a deviation between the initial calibration datum and theoretical calculation datum exceeds a first threshold, wherein the theoretical calculation datum is a theoretical status parameter of the electric machine running under the preset calibration parameter, and the theoretical calculation datum is obtained by calculating based on the preset calibration parameter; and
   a first calibration module (420), configured to re-calibrate the electric machine based on the preset calibration parameter after the first determining module (410) determines that the deviation between the initial calibration datum and the theoretical calculation datum exceeds the first threshold, and obtain an updated calibration datum, **characterized in that**
   the first determining module (410) is further configured to determine whether a deviation between the updated calibration datum and the initial calibration datum exceeds a second threshold; and
   a first update module (430), configured to update the initial calibration datum based on the updated calibration datum after the first determining module (410) determines that the deviation between the updated calibration datum and the initial calibration datum does not exceed the second threshold.

6. An electronic device (9), comprising a memory (902) and a processor (901), wherein the memory (902) stores a computer program, **characterized in that**, when executing the computer program, the processor (901) implements the method according to any one of claims 1 to 4.

7. A storage medium on which a computer program is stored, **characterized in that**, when executed by a processor (801), the computer program implements the method according to any one of claims 1 to 4.

**Patentansprüche**

1. Verfahren zum Aktualisieren von Kalibrierungsdaten einer elektrischen Maschine, wobei das Verfahren umfasst:

   (S100) Erhalten eines anfänglichen Kalibrierungsdatums der elektrischen Maschine, wobei das anfängliche Kalibrierungsdatum ein Statusparameter der elektrischen Maschine ist, die unter einem voreingestellten Kalibrierungsparameter läuft;
   (S110) Bestimmen, ob eine Abweichung zwischen dem anfänglichen Kalibrierungsdatum und einem theoretischen Berechnungsdatum einen ersten Schwellenwert überschreitet, wobei das theoretische Berechnungsdatum ein theoretischer Statusparameter der elektrischen Maschine ist, die unter dem voreingestellten Kalibrierungsparameter läuft, und das theoretische Berechnungsdatum durch Berechnung basierend auf dem voreingestellten Kalibrierungsparameter erhalten wird;
   (S120) Rekalibrierung der elektrischen Maschine basierend auf dem voreingestellten Kalibrierungsparameter, wenn die Abweichung zwischen dem anfänglichen Kalibrierungsdatum und dem theoretischen Berechnungsdatum den ersten Schwellenwert überschreitet, und Erhalten eines aktualisierten Kalibrierungsdatums;
   **dadurch gekennzeichnet, dass**
   das Verfahren ferner umfasst:

   (S130) Bestimmen, ob eine Abweichung zwischen dem aktualisierten Kalibrierungsdatum und dem anfänglichen Kalibrierungsdatum einen zweiten Schwellenwert überschreitet; und

(S140) Aktualisieren des anfänglichen Kalibrierungsdatums basierend auf dem aktualisierten Kalibrierungsdatum, wenn die Abweichung zwischen dem aktualisierten Kalibrierungsdatum und dem anfänglichen Kalibrierungsdatum den zweiten Schwellenwert nicht überschreitet.

2. Verfahren nach Anspruch 1, **dadurch gekennzeichnet, dass** das Verfahren ferner umfasst:

(S200) Neukalibrierung der elektrischen Maschine basierend auf dem voreingestellten Kalibrierungsparameter, wenn die Abweichung zwischen dem aktualisierten Kalibrierungsdatum und dem anfänglichen Kalibrierungsdatum den zweiten Schwellenwert überschreitet, und Erhalten eines zweiten aktualisierten Kalibrierungsdatums;

(S210) Bestimmen, ob eine Abweichung zwischen dem zweiten aktualisierten Kalibrierungsdatum und dem aktualisierten Kalibrierungsdatum den zweiten Schwellenwert überschreitet; und

(S220) Aktualisieren des anfänglichen Kalibrierungsdatums basierend auf dem zweiten aktualisierten Kalibrierungsdatum, wenn die Abweichung zwischen dem zweiten aktualisierten Kalibrierungsdatum und dem aktualisierten Kalibrierungsdatum den zweiten Schwellenwert nicht überschreitet.

3. Verfahren nach Anspruch 1, **dadurch gekennzeichnet, dass** das Bestimmen (S110), ob eine Abweichung zwischen dem anfänglichen Kalibrierungsdatum und dem theoretischen Berechnungsdatum einen ersten Schwellenwert überschreitet, umfasst:

Bestimmen, ob eine Differenz zwischen dem anfänglichen Kalibrierungsdatum und dem theoretischen Berechnungsdatum den ersten Schwellenwert überschreitet; oder Bestimmen, ob ein Verhältnis des anfänglichen Kalibrierungsdatums zum theoretischen Berechnungsdatum den ersten Schwellenwert überschreitet.

4. Verfahren nach Anspruch 1, **dadurch gekennzeichnet, dass** das Bestimmen (S130), ob eine Abweichung zwischen dem aktualisierten Kalibrierungsdatum und dem anfänglichen Kalibrierungsdatum einen zweiten Schwellenwert überschreitet, umfasst:

Bestimmen, ob ein Absolutwert einer Differenz zwischen dem aktualisierten Kalibrierungsdatum und dem anfänglichen Kalibrierungsdatum den zweiten Schwellenwert überschreitet; oder Bestimmen, ob ein Absolutwert eines Verhältnisses des aktualisierten Kalibrierungsdatums zum anfänglichen Kalibrierungsdatum den zweiten Schwellenwert überschreitet.

5. Vorrichtung zur Aktualisierung von Kalibrierungsdaten einer elektrischen Maschine, **dadurch gekennzeichnet, dass** die Vorrichtung aufweist:

ein erstes Erlangungsmodul (400), das konfiguriert ist, einen Anfangskalibrierungsdatenwert der elektrischen Maschine zu erhalten, wobei der Anfangskalibrierungsdatenwert ein Statusparameter der elektronischen Maschine ist, die unter einem voreingestellten Kalibrierungsparameter läuft;

ein erstes Bestimmungsmodul (410), das konfiguriert ist, um zu bestimmen, ob eine Abweichung zwischen dem anfänglichen Kalibrierungsdatum und dem theoretischen Berechnungsdatum einen ersten Schwellenwert überschreitet, wobei das theoretische Berechnungsdatum ein theoretischer Statusparameter der elektrischen Maschine ist, die unter dem voreingestellten Kalibrierungsparameter läuft, und das theoretisch Berechnungsdatum durch Berechnung auf Grundlage des voreingestellten Kalibrierungsparameters ermittelt wird; und

ein erstes Kalibrierungsmodul (420), das konfiguriert ist, die elektrische Maschine basierend auf dem voreingestellten Kalibrierungsparameter neu zu kalibrieren, nachdem das erste Bestimmungsmodul (410) bestimmt hat, dass die Abweichung zwischen dem anfänglichen Kalibrierungsdatum und dem theoretischen Berechnungsdatum den ersten Schwellenwert überschreitet, und ein aktualisiertes Kalibrierungsdatum zu erhalten, **dadurch gekennzeichnet, dass**

das erste Bestimmungsmodul (410) ferner konfiguriert ist, um zu bestimmen, ob eine Abweichung zwischen dem aktualisierten Kalibrierungsdatum und dem anfänglichen Kalibrierungsdatum einen zweiten Schwellenwert überschreitet; und

ein erstes Aktualisierungsmodul (430), das konfiguriert ist, um das anfängliche Kalibrierungsdatum basierend auf dem aktualisierten Kalibrierungsdatum zu aktualisieren, nachdem das erste Bestimmungsmodul (410) bestimmt, dass die Abweichung zwischen dem aktualisierten Kalibrierungsdatum und dem anfänglichen Kalibrierungsdatum den zweiten Schwellenwert nicht überschreitet.

6. Elektronische Vorrichtung (9), aufweisend einen Speicher (902) und einen Prozessor (901), wobei der Speicher (902) ein Computerprogramm speichert, **dadurch gekennzeichnet, dass** der Prozessor (901) beim Ausführen des Computerprogramms das Verfahren nach einem der Ansprüche 1 bis 4 implementiert.

**7.** Speichermedium, auf dem ein Computerprogramm gespeichert ist, **dadurch gekennzeichnet, dass** das Computerprogramm dann, wenn es von einem Prozessor (801) ausgeführt wird, das Verfahren nach einem der Ansprüche 1 bis 4 implementiert.

**Revendications**

**1.** Procédé de mise à jour de données d'étalonnage d'une machine électrique, dans lequel le procédé comprend :

(S100) l'obtention d'une donnée d'étalonnage initiale de la machine électrique, dans lequel la donnée d'étalonnage initiale est un paramètre d'état de la machine électrique fonctionnant sous un paramètre d'étalonnage prédéfini ;
(S110) la détermination si oui ou non un écart entre la donnée d'étalonnage initiale et une donnée de calcul théorique dépasse un premier seuil, dans lequel la donnée de calcul théorique est un paramètre d'état théorique de la machine électrique fonctionnant sous le paramètre d'étalonnage prédéfini, et la donnée de calcul théorique est obtenue par calcul sur la base du paramètre d'étalonnage prédéfini ; et
(S120) le réétalonnage de la machine électrique sur la base du paramètre d'étalonnage prédéfini lorsque l'écart entre la donnée d'étalonnage initiale et la donnée de calcul théorique dépasse le premier seuil, et l'obtention d'une donnée d'étalonnage mise à jour ;
**caractérisé en ce que**
le procédé comprend en outre :

(S130) la détermination si oui ou non un écart entre la donnée d'étalonnage mise à jour et la donnée d'étalonnage initiale dépasse un second seuil ; et
(S140) la mise à jour de la donnée d'étalonnage initiale sur la base de la donnée d'étalonnage mise à jour lorsque l'écart entre la donnée d'étalonnage mise à jour et la donnée d'étalonnage initiale ne dépasse pas le second seuil.

**2.** Procédé selon la revendication 1, **caractérisé en ce que** le procédé comprend en outre :

(S200) le réétalonnage de la machine électrique sur la base du paramètre d'étalonnage prédéfini lorsque l'écart entre la donnée d'étalonnage mise à jour et la donnée d'étalonnage initiale dépasse le second seuil, et l'obtention d'une seconde donnée d'étalonnage mise à jour ;
(S210) la détermination si oui ou non un écart entre la seconde donnée d'étalonnage mise à jour et la donnée d'étalonnage mise à jour dépasse le second seuil ; et
(S220) la mise à jour de la donnée d'étalonnage initiale sur la base de la seconde donnée d'étalonnage mise à jour lorsque l'écart entre la seconde donnée d'étalonnage mise à jour et la donnée d'étalonnage mise à jour ne dépasse pas le second seuil.

**3.** Procédé selon la revendication 1, **caractérisé en ce que** la détermination (110) si oui ou non un écart entre la donnée d'étalonnage initiale et la donnée de calcul théorique dépasse un premier seuil comprend :
la détermination si oui ou non une différence entre la donnée d'étalonnage initiale et la donnée de calcul théorique dépasse le premier seuil ; ou, la détermination si oui ou non un rapport entre la donnée d'étalonnage initiale et la donnée de calcul théorique dépasse le premier seuil.

**4.** Procédé selon la revendication 1, **caractérisé en ce que** la détermination (S130) si oui ou non un écart entre la donnée d'étalonnage mise à jour et la donnée d'étalonnage initiale dépasse un second seuil comprend :
la détermination si oui ou non une valeur absolue entre la donnée d'étalonnage mise à jour et la donnée d'étalonnage initiale dépasse le second seuil ; ou, la détermination si oui ou non une valeur absolue d'un rapport entre la donnée d'étalonnage mise à jour et la donnée d'étalonnage initiale dépasse le second seuil.

**5.** Dispositif de mise à jour de données d'étalonnage d'une machine électrique, dans lequel le dispositif comprend :

un premier module d'obtention (400), configuré pour obtenir une donnée d'étalonnage initiale de la machine électrique, dans lequel la donnée d'étalonnage initiale est un paramètre d'état de la machine électrique fonctionnant sous un paramètre d'étalonnage prédéfini ;
un premier module de détermination (410), configuré pour déterminer si oui ou non un écart entre la donnée d'étalonnage initiale et la donnée de calcul théorique dépasse un premier seuil, dans lequel la donnée de calcul théorique est un paramètre d'état théorique de la machine électrique fonctionnant sous le paramètre d'état prédéfini, et la donnée de calcul théorique est obtenue par calcul sur la base du paramètre d'étalonnage prédéfini ; et

un premier module d'étalonnage (420), configuré pour réétalonner la machine électrique sur la base du paramètre d'étalonnage prédéfini après que le premier module de détermination (410) détermine que l'écart entre la donnée d'étalonnage initiale et la donnée de calcul théorique dépasse le premier seuil, et obtient une donnée d'étalonnage mise à jour,

**caractérisé en ce que**

le premier module de détermination (410) est en outre configuré pour déterminer si oui ou non un écart entre la donnée d'étalonnage mise à jour et la donnée d'étalonnage initiale dépasse un second seuil ; et

un premier module de mise à jour (430), configuré pour mettre à jour la donnée d'étalonnage initiale sur la base de la donnée d'étalonnage mise à jour après que le premier module de détermination (410) détermine que l'écart entre la donnée d'étalonnage mise à jour et la donnée d'étalonnage initiale ne dépasse pas le second seuil.

6. Dispositif électronique (9), comprenant une mémoire (902) et un processeur (901), dans lequel la mémoire (902) stocke un programme informatique, **caractérisé en ce que**, lors de l'exécution du programme informatique, le processeur (901) met en oeuvre le procédé selon l'une quelconque des revendications 1 à 4.

7. Support d'enregistrement sur lequel un programme informatique est stocké, **caractérisé en ce que**, lorsqu'il est exécuté par un processeur (801), le programme informatique met en oeuvre le procédé selon l'une quelconque des revendications 1 à 4.

Obtaining an initial calibration datum of an electric machine — S100

Determining whether a deviation between the initial calibration datum and a theoretical calculation datum exceeds a first threshold — S110

Determining that the initial calibration datum is accurate — S121

Yes

Re-calibrating the electric machine based on a preset calibration parameter, and obtaining an updated calibration datum — S120

Determining whether a deviation between the updated calibration datum and the initial calibration datum exceeds a second threshold — S130

No

Re-calibrating the electric machine based on the preset calibration parameter, and obtaining an updated calibration datum — S140

FIG. 1

Re-calibrating the electric machine based on a preset calibration parameter, and obtaining an updated calibration datum — S120

Determining whether a deviation between the updated calibration datum and the initial calibration datum exceeds a second threshold — S130

No →

Updating the initial calibration datum based on the updated calibration datum — S140

Yes ↓

Re-calibrating the electric machine based on the preset calibration parameter, and obtaining a second updated calibration datum — S200

Determining whether a deviation between the second updated calibration datum and the updated calibration datum exceeds the second threshold — S210

No ↓

Updating the initial calibration datum based on the second updated calibration datum — S220

FIG. 2

```
┌─────────────────────────────────────────┐
│ Re-calibrating the electric machine based on a │ ⟋ S120
│ preset calibration parameter, and obtaining an  │
│        updated calibration datum                │
└─────────────────────────────────────────┘
                    │
                    ▼
```

Determining whether a deviation between the updated calibration datum and the initial calibration datum exceeds a second threshold — S130

No →

Updating the initial calibration datum based on the updated calibration datum — S140

Yes ↓

Re-calibrating the electric machine based on the preset calibration parameter, and obtaining a current updated calibration datum — S300

Determining whether a deviation between the current updated calibration datum and a previously calibrated updated calibration datum exceeds the second threshold — S310

Yes →

No ↓

Updating the initial calibration datum based on the current updated calibration datum — S320

FIG. 3

First
obtaining
module — 400

First
determining
module — 410

First
calibration
module — 420

First update
module — 430

FIG. 4

Obtaining a lookup table of an electric machine — S500

Determining, based on each initial calibration datum and a corresponding theoretical calculation datum, whether a to-be-updated initial calibration datum exists in a plurality of initial calibration data — S510

No → Determining that the plurality of initial calibration data in the lookup table are all accurate — 521

Yes

Re-calibrating the electric machine based on a calibration parameter corresponding to each to-be-updated initial calibration datum, and obtaining an updated calibration datum corresponding to each to-be-updated initial calibration datum — S520

Determining whether a deviation between each updated calibration datum among at least one updated calibration datum and a corresponding to-be-updated initial calibration datum exceeds a second threshold — S530

No

Updating the corresponding to-be-updated initial calibration datum based on the updated calibration datum that deviates by the deviation not exceeding the second threshold — S540

FIG. 5

Re-calibrating the electric machine based on a calibration parameter corresponding to each to-be-updated initial calibration datum, and obtaining an updated calibration datum corresponding to each to-be-updated initial calibration datum — S520

Determining whether a deviation between each updated calibration datum among at least one updated calibration datum and a corresponding to-be-updated initial calibration datum exceeds a second threshold — S530

No → Updating the corresponding to-be-updated initial calibration datum based on the updated calibration datum that deviates by the deviation not exceeding the second threshold — S540

Yes

Re-calibrating the electric machine based on a calibration parameter corresponding to each updated calibration datum that deviates by the deviation exceeding the second threshold, and obtaining a second updated calibration datum corresponding to each updated calibration datum that deviates by the deviation exceeding the second threshold — S600

Determining whether a deviation between each second updated calibration datum among at least one second updated calibration datum and a corresponding updated calibration datum exceeds the second threshold — S610

No

Updating the corresponding initial calibration datum based on the second updated calibration datum that deviates by the deviation not exceeding the second threshold — S620

FIG. 6

Re-calibrating the electric machine based on a calibration parameter corresponding to each to-be-updated initial calibration datum, and obtaining an updated calibration datum corresponding to each to-be-updated initial calibration datum — S520

Determining whether a deviation between each updated calibration datum among at least one updated calibration datum and a corresponding to-be-updated initial calibration datum exceeds a second threshold — S530

No

Updating the corresponding to-be-updated initial calibration datum based on the updated calibration datum that deviates by the deviation not exceeding the second threshold — S540

Yes

Re-calibrating the electric machine based on a calibration parameter corresponding to each updated calibration datum that deviates by the deviation exceeding the second threshold, and obtaining a current updated calibration datum corresponding to each updated calibration datum that deviates by the deviation exceeding the second threshold — S700

Determining, for the current updated calibration datum corresponding to each current updated calibration datum that deviates by the deviation exceeding the second threshold, whether a deviation between the current updated calibration datum and the previously calibrated updated calibration datum exceeds the second threshold — S710

Yes

No

Updating the corresponding initial calibration datum based on the current updated calibration datum corresponding to the updated calibration datum that deviates by the deviation not exceeding the second threshold — S720

FIG. 7

FIG. 8

FIG. 9

**REFERENCES CITED IN THE DESCRIPTION**

**Non-patent literature cited in the description**

- Machine learning for the control and monitoring of electric machine drives: Advances and Trends. **SHEN ZHANG et al.** Arxiv.org. Cornell University Library, 201 OLIN Library Cornell University, 18 February 2023